# EUROPEAN PATENT SPECIFICATION

(11) **EP 2 781 574 B1**
(45) Date of publication and mention of the grant of the patent: **16.11.2016**
(21) Application number: 12850642.5
(22) Date of filing: 06.02.2012
(51) Int. Cl.: C09K 11/80, H01L 33/26, B82Y 30/00, B32B 7/02, B82B 1/00, B82Y 40/00, B82Y 20/00, B32B 27/30, H01L 33/50, C09K 11/02

(54) **LUMINESCENT COMPOSITE MATERIAL AND LIGHT-EMITTING DEVICE BASED THEREON**
LUMINESZIERENDES VERBUNDMATERIAL UND DARAUF BASIERENDE LICHTEMITTIERENDE VORRICHTUNG
MATÉRIAU COMPOSITE LUMINESCENT ET DISPOSITIF D'ÉCLAIRAGE LE COMPRENANT

(30) Priority: 18.11.2011 RU 2011146673
(43) Date of publication of application: 24.09.2014
(73) Proprietor: Obschestvo s Ogranichennoi Otvetstvennostyu "Lumen", (OOO "Lumen), Saransk 430034 (RU)
(72) Inventor: VAKSHTEYN, Maksim Sergeevich, Dubna Moskovskaya obl. 141980 (RU); DEZHUROV, Sergey Valeryevich, Kurgan 640001 (RU); NAZARKIN, Arseniy Vladimirovich, Dubna Moskovskaya obl. 141983 (RU); TRUKHAN, Vladimir Mikhailovich, Chernogolovka Moskovskaya obl. 142432 (RU)
(74) Representative: Sloboshanin, Sergej
(86) International application number: PCT/RU2012/000065
(87) International publication number: WO 2013/073986

(56) References cited:
- WO-A1-03/084292
- WO-A2-2007/009010
- RU-C1- 2 416 841
- US-A1- 2005 051 777
- US-A1- 2005 142 371
- US-A1- 2010 123 155
- US-A1- 2010 264 371
- US-A1- 2011 090 670

## Description

### FIELD OF THE INVENTION

The invention relates to lighting engineering, namely to a luminescent composite material containing semiconductor nanoparticles in particular, which may be used in the manufacture of general and localized lighting devices used as a source of white light, and to a device based thereon.

### PRIOR ART

The proposed invention deals with a luminescent composite material used in LEDs to produce white light, as well as with devices made using this material. White light is produced by mixing blue light from the LED and the one re-emitted by a long-wave phosphor included in the luminescent composition of this composite material.

At present, LED lamps use high power LEDs with temperature on the chip reaching 80-100°C during operation. A high LED temperature results in a decrease in efficiency and an increase in the phosphor degradation rate applied directly on the chip or located in the close vicinity to the chip. As a result, durability of the device is limited by thermal stability of phosphor, which is a part of it. It should be noted separately that white light of the modem LED systems to be used for interior lighting of residential and office space require high color rendering index (CRI more 80).

To obtain white light using a blue LED a method of applying yellow phosphor such as yttrium aluminum garnet, or a mixture of red and yellow-green phosphors directly on the surface of blue LED is widely recognized. However, the use of LED systems containing a single phosphor only, for general indoor lighting has significant limitations due to poor light generated by such systems (color rendering index or CRI <75). In turn, the use of several phosphors requires optimization of their ratio in the light-converting material, their application sequence and selection of a method of applying them. However, simple mixing of phosphors cannot provide high light conversion efficiency.

A device for producing white light from LED light source is known as disclosed in WO 2007/009010 A2, H01L 33/00, iss. 18.01.2007, which consists of a LED chip that emits at a single wavelength of semiconductor nanocrystals, absorbing at least the first portion of light from the chip and re-emitting it at the second wavelength, and the phosphor powder, which absorbs at least the second part of light from the LED chip and re-emits at the third wavelength. The device improves quality of white light emitted from the LED light source, color rendering index improved and the correlated color temperature decreased, in particular, with a slight deterioration of the overall system effectiveness. This is achieved by using a mixture of phosphors comprising semiconductor nanocrystals emitting at red-orange (600-650 nm) and green-blue (490-530 nm) wavelength ranges.

The disadvantages are, firstly, the application of phosphors directly on the LED chip that leads to faster thermal degradation of the phosphor, as the nanocrystals have a low thermal stability, and therefore reduce the life of the LED light source; and secondly, using a mixture of phosphors, instead of separate lamination, leading to general reduction of the LED light source efficiency.

An invention is also known disclosed in the application US 2011/187262 A1, H01J 1/62, iss. 04.08.2011, which comprises a light emitting diode and a permeable spherical membrane covered inside and outside by a layer containing phosphor. This invention employs conventional phosphors based on yttrium-aluminum garnets, silicates, silicon nitride, sulfides, in which emission in the red region is due to rare earth element in the form of a dopant (such as europium). Using the red phosphor ensures high color rendering index (CRI > 90) for the color temperature up to 2700 K. However, the red phosphors based on europium have several disadvantages. At first, it is poor resistance to moisture and air oxygen that leads to rapid degradation of the phosphor. Secondly, the spectrum region is the near infrared region (not perceived by the human eye) that reduces the efficiency of the whole system.

Thirdly, it is high material consumption as micron or submicron size particle are used, as well as additional loss of efficiency due to light scattering by large particles.

Insufficiently high efficiency of light conversion from the primary LED light source by said source structure coated with phosphor membrane in the case of using a mixture of phosphors may also be indicated as a disadvantage. This is due to the fact that the conversion efficiency is influenced by the sequence of layers of different phosphors, and both thickness of these layers and the ratio of phosphors in various layers.

A LED structure with a phosphor containing a crystal, a conical reflector and a phosphor located remotely from the crystal is known (Russian Patent No. 2416841 C1, H01L 33/00, iss. 20.04.11). The invention allows for an increase in the efficiency of lateral emission of the crystal converted to radiation of phosphor applied on the inclined surface of the reflector. The authors succeeded in obtaining a uniform colority of white light LEDs in different directions due to a wide radiation pattern of the phosphor used. Furthermore, the use of white reflector surface can reflect the downward emission of the phosphor located on the reflector that increases the light output of the LED. As a result, the LED light output increases by 20-30%, and the uniformity of color emission is improved.

However, the use of a single phosphor in this invention does not fully cover the range from blue to red and thus does not allow obtaining white light with high color rendering index.

Technical solution disclosed in the US Application 2011/0090670 AI, B32B 3/00, C09J 7/02, iss. 21.04.2011 which comprises a luminescent material and a light emitting device thereon, has been chosen as a prototype. One of the embodiments of the said technical solution is a fluorescent material composed of, among other things, a layer containing phosphors based on silicates, sulfides, yttrium-aluminum and terbium-aluminum garnets. Another embodiment of this solution is an apparatus for producing white light with high color index which comprises an optical film consisting of a fluorescent material excited by light emitted from the LED chip so that the light transmitted through the optical film has color rendering index between 85 and 100. Fluorescent material allows create of a light source that has color rendering index ranged between 85 and 100 with correlated color temperatures in the range of 3000 - 5000 K.
The main disadvantage of this solution is the use of rare earth phosphor elements that have low thermal stability, and low photostability upon exposure to moisture and oxygen. In addition, this solution has limitations associated with the use of precisely the film material.

### DISCLOSURE OF THE INVENTION

The purpose of this invention is to provide a fluorescent composite material, and the light emitting device on the basis thereof to produce white light. Fluorescent composite material can be used in LED lighting devices of general and localized lighting in order to improve their efficiency, durability, providing comfortable light to the human eye (conforming to sanitary standards) from the lighting device through implementation of the given correlated color temperature and color rendering index.

The technical result consists in increasing photo- and thermal stability, as well as in improving the resistance to environmental luminescent composite material by using a new type of fluorescent semiconductor nanocrystals in its composition, relating to the following type: "core/first semiconductor shell/second semiconductor shell". Hereafter referred to as the following notations of semiconductor nanocrystals are used: core/first semiconductor shell/second semiconductor shell. For example, CdSe/CdS/ZnS.

Both engineering problems and problems of composition, thickness and the sequence of applying functional layers are solved in the proposed fluorescent composite material. As a result, this material allows for creating LED white light sources with a color rendering index of 80 or higher, correlated color temperature ranged from 2500 to 5000 K, the luminous efficiency over 100 lm/W and service life of 50,000 hours or more.

The task in hand is solved and the technical result is achieved in that the fluorescent composite material comprises a polymeric matrix formed from an optically transparent polymeric material and a multilayer polymeric film comprising phosphors, wherein a multilayer polymeric film consists of at least three layers, one of which represents an optically transparent polymer film, the other is the polymeric composition with dispersed semiconductor nanocrystals, and the third layer is a polymeric composition comprising inorganic phosphors. Semiconductor nanocrystals are made of a semiconductor core, the first semiconductor layer and the second semiconductor layer and emit a fluorescent signal with fluorescence peak maxima in the wavelength range of 580 - 650 nm.

The task in hand is also solved and the technical result is achieved in that the light emitting device for producing white light contains a light source and a luminescent composite material located remotely from the light source. Meanwhile, the light source is designed as a light diode with the wavelength ranged within 430 - 470 nm, a part of radiation of which passes through the phosphor composite material undergoing no changes, and another part of radiation is absorbed by the phosphor composite material representing a polymer matrix made of optically transparent polymer material with a multilayer polymeric film consisting of at least three layers, one of which is a polymeric composition comprising inorganic phosphors, the second is optically transparent polymeric material and the third is polymer composition with dispersed semiconductor nanocrystals. These nanocrystals are formed as a semiconductor core, the first semiconductor layer and the second semiconductor layer and emit a fluorescent signal with fluorescence peak maxima in the wavelength range of 580 - 650 nm, whereby the radiation received at the output of the luminescent composite material gives white light with the color rendering index greater than 80.

### BRIEF DESCRIPTION OF DRAWINGS

The claimed group of inventions is illustrated by drawings showing:
**Fig. 1** **-** Fluorescent Composite Material (option 1);
**Fig. 2** **-** Fluorescent Composite Material (option 2);
**Fig. 3** **-** Fluorescence spectrum of semiconductor nanocrystals InP/CdSe/ZnSe;
**Fig. 4** **-** Fluorescence spectrum of semiconductor nanocrystals CdSe/CdS/ZnS;
**Fig. 5** **-** Fluorescence spectrum of semiconductor nanocrystals CuInS₂/ZnSe/ZnS;
**Fig. 6** **-** Fluorescence spectrum of the luminescent composite material (option 1);
**Fig. 7** **-** Fluorescence spectrum of luminescent composite material (option 2);
**Fig. 8** **-** Light emitting device;
**Fig. 9** **-** Light-emitting device with a reflector.
**Fig. 10** **-** Plot of emission intensity variation (signal detection at 620 nm) for the light-emitting device based on the LED chip (450 nm, 12 W) and fluorescent composite materials:
   known and proposed, for 2,000 hours in the temperature range of 30-50°C.

### INVENTION EMBODIMENTS

For obtaining white light using a blue light source a new luminescent composite material is proposed which is obtained as follows.

The polymeric matrix 1 made by any known method, for example, by injection molding, with the addition of diffuser-based additives TiO₂, SiO₂, ZnO, BaSO₄, CaCO₃ or spherical polymeric particles, if required. The polymer matrix 1 can be made from optically transparent polymeric material selected from the following group: polycarbonate, polymethylmethacrylate, polyvinylchloride or polystyrene, wherein the matrix 1 is from 0.5 to 3 mm thick.

A multilayer polymeric film is formed by applying optically transparent polymer film 2 by any known method, for example, by successive printing of polymer composition 3 layer consisting of an inorganic phosphor which luminesce in the green-yellow spectrum region, and the polymer composition 4 layer with dispersed semiconductor nanocrystals luminescing in the orange-red spectrum region.

In the preferred embodiment, the inorganic phosphor is dispersed in the bulk polymeric composition selected from the group of yttrium-aluminum garnets doped with cerium- or gallium-gadolinium garnets doped with cerium.

In the preferred embodiment, semiconductor nanocrystals represent a semiconductor core consisting of a semiconductor material selected from the group of CdS, CdSe, CdTe, InP, InAs, CuInS₂, CuInSe₂, the first semiconductor layer consisting of a semiconductor material selected from the group: ZnS, ZnSe, ZnTe, CdS, CdSe, CdTe, InP, InAs; and the second semiconductor layer consisting of a semiconductor material selected from the group: ZnS, ZnSe, ZnTe, CdS, CdSe, CdTe, InP, InAs.

The above structures of semiconductor nanocrystals provide increased relative fluorescence quantum yield to 90% or higher. In this case, thermal stability and photostability of said nanocrystals allow their use in light-emitting devices with the lifetime of 50,000 hours or longer.

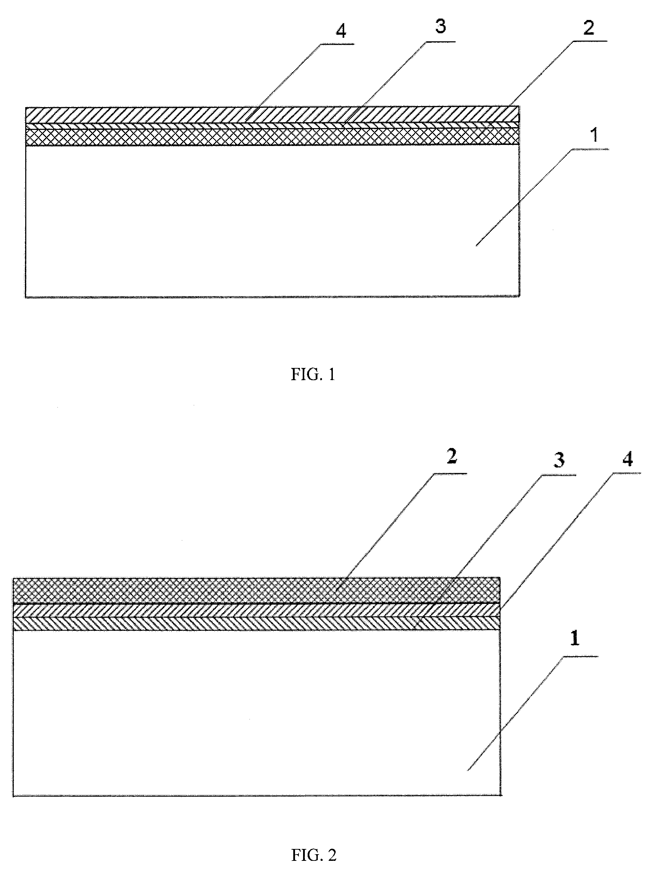

**Fig. 1** provides a schematic of the luminescent composite material comprising a matrix 1 and a multilayer polymeric film consisting of three layers arranged with respect to the polymeric matrix 1 as follows: a polymer film 2, a polymer composition 3 comprising an inorganic phosphor, a polymer composition 4 with dispersed semiconductor nanocrystals.

Meanwhile, this polymer film 2 may be made of a polymeric material selected from the group: polycarbonate, polymethylmethacrylate, polyvinylchloride or polystyrene, may include in the composition a light-scattering additive based on TiO₂, SiO₂, ZnO, BaSO₄, CaCO₃ or a light scattering additive in the form of spherical polymer particles, if required.

The polymer composition may be formed from a polymeric material selected from the group of polymethylmethacrylate, polyisocyanate or mixtures thereof, and may include in its composition a light-scattering additive, based on TiO₂, SiO₂, ZnO, BaSO₄, CaCO₃ or a light scattering additive in the form of spherical polymer particles, if required.

The multilayer polymeric film is attached to the surface of the polymer matrix 1. The inorganic phosphor and semiconductor nanocrystals are chosen in such a way that a combination of their fluorescence spectra overlap the wavelength range of 480 - 650 nm. Fluorescence quantum yields of the inorganic phosphor and semiconductor nanocrystals must be at least 90%.

**Fig. 2** schematically shows another embodiment of the luminescent composite material comprising the matrix 1 and the multilayer polymeric film consisting of three layers arranged relative to the polymer film as follows: the polymer composition 3 comprising an inorganic phosphor, the polymer composition 4 with dispersed semiconductor nanocrystals, and optically transparent polymer film 2.

The number of layers in a multilayer polymeric film depends on the specific tasks and may be any, but should not be less than three. These examples are not limited all possible combinations of layers in the multilayer polymeric film, and are only described for the purpose of the claimed material embodiment to be verified as defined in the first independent claim.

Thus the inorganic phosphor layer should be located closer to the blue light source than the layer of semiconductor nanocrystals. Phosphor and semiconductor nanocrystals concentrations, and thickness of the respective layers are selected so that the CCT and CRI of white light emitted by the light-emitting device comprising a light source and a luminous composite material located remotely from the light source fall within the range of 2500 - 5000 K and 80-100, respectively.

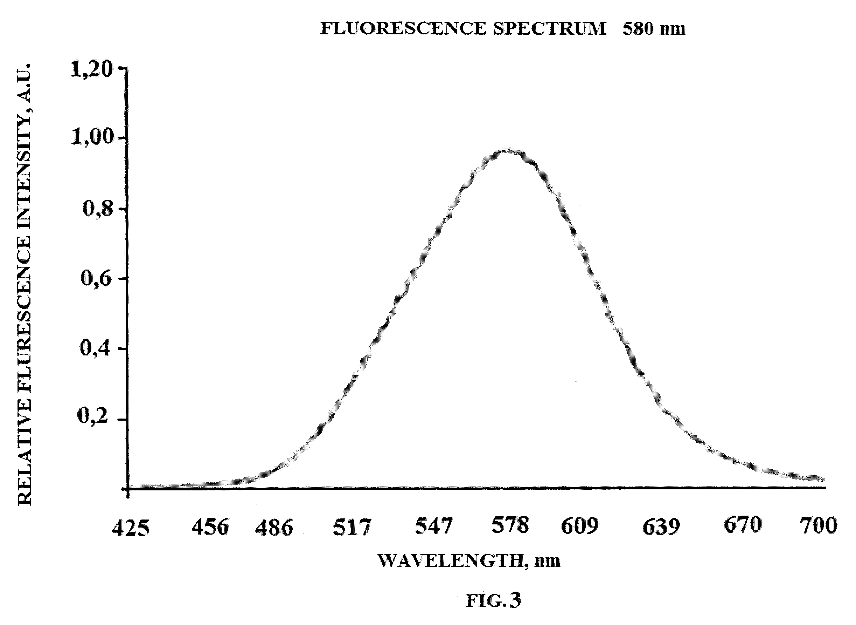

**Fig. 3** shows the fluorescence spectrum of semiconductor nanocrystals InP/CdSe/ZnSe. The maximum fluorescence wavelength was 580 nm.

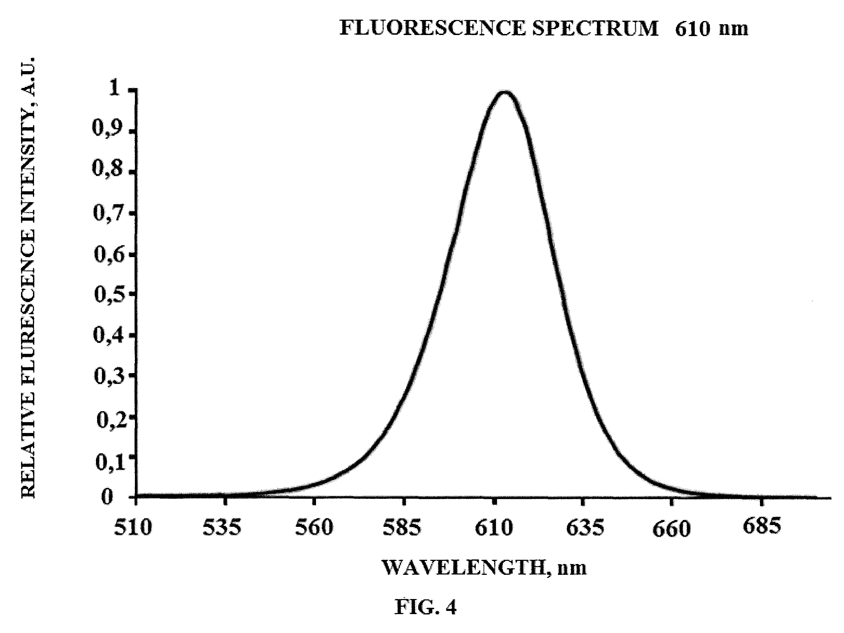

**Fig. 4** shows the fluorescence spectrum of the semiconductor nanocrystal CdSe/CdS/ZnS. The maximum fluorescence wavelength was 610 nm.

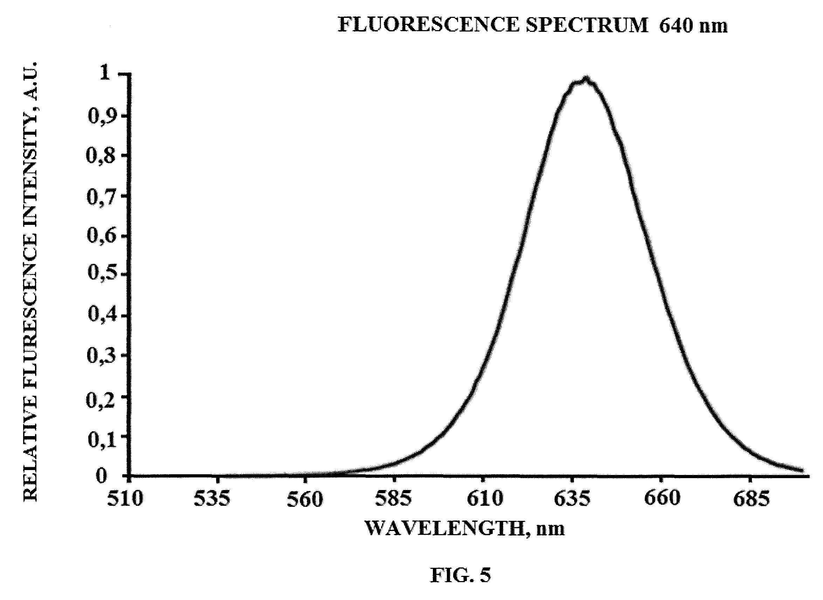

**Fig. 5** shows the fluorescence spectrum of the semiconductor nanocrystal CuInS₂/ZnSe/ZnS. The maximum fluorescence wavelength was 640 nm.

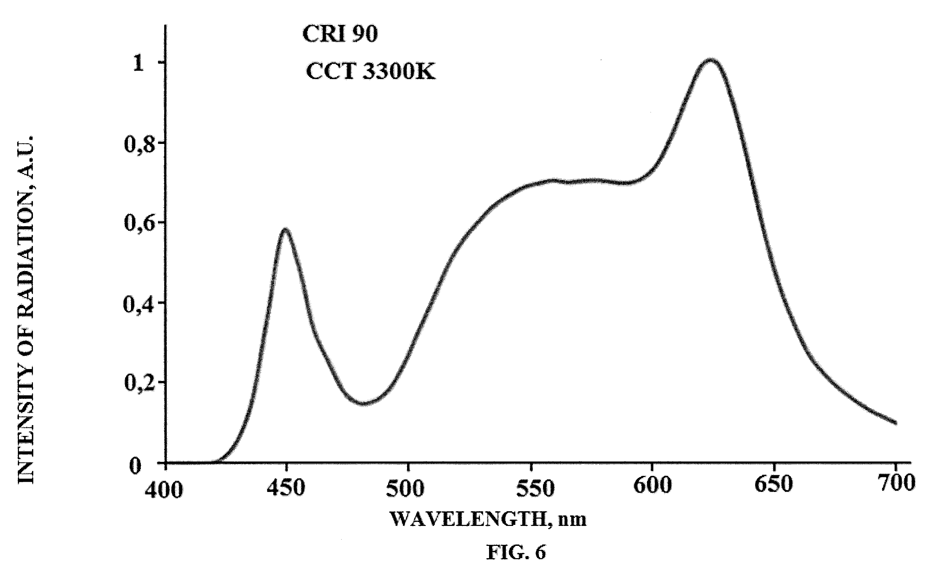

**Fig. 6** shows the fluorescence spectrum of the luminescent composite material comprising a polymeric multilayer film with the layer sequence shown in **Fig. 1****,** with Color Rendering Index 90 and correlated color temperature of 3300 K.

The luminescent composite material consists of an optically transparent polymer material, made of polymethylmethacrylate 0.5 mm thick, optically transparent polymeric film made of a polymethylmethacrylate, polymer compositions based on polymethylmethacrylate which comprises yellow phosphor (yttrium-aluminum garnet doped with cerium), a polymethylmethacrylate-based polymer composition with dispersed nanocrystals of the structure CdSe/CdS/ZnS with a maximum fluorescence wavelength of 620 nm.

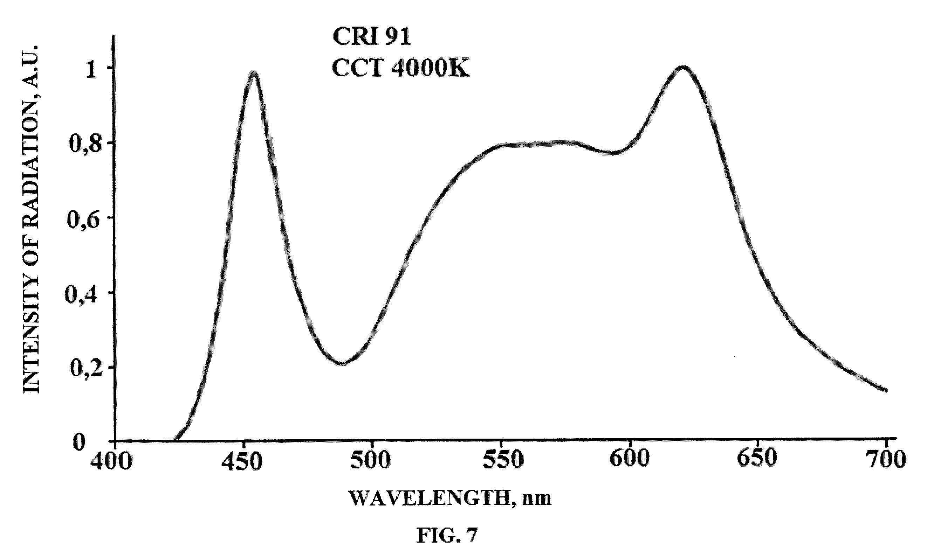

**Fig. 7** shows the fluorescence spectrum of the luminescent material composite comprising a multilayered polymer film with the sequence of layers illustrated in **Fig. 2****,** with Color Rendering Index 91 and correlated color temperature of 4000 K.

The luminescent composite material consists of an optically transparent polymer material 3 mm thick and made of polycarbonate, with the diffuser additive TiO₂, optically transparent polymeric film made of polycarbonate with the diffuser additive SiO₂, polymethylmethacrylate-based polymer composition comprising gadolinium-gallium garnet doped with cerium, with the diffuser additive ZnO, polymethylmethacrylate-based polymer composition with the diffuser additive SiO₂ and dispersed nanocrystals of CdSe/CdS/ZnS structure with a maximum fluorescence wavelength of 620 nm.

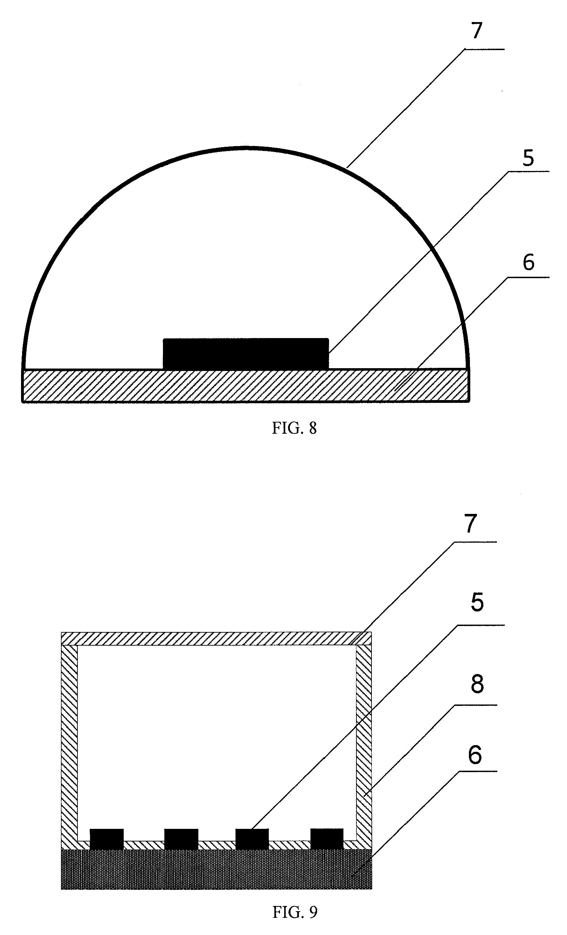

**Fig. 8** shows one of the embodiments of the light emitting device to produce white light, comprising the light source 5, and the heat sink material 6 and luminescent composite material 7 located remotely from the light source as described above. The light source 5 represents a LED with the wavelength range of 430 - 470 nm. A part of radiation from the light source 5 passes through the luminescent composite material 7 unchanged, and another part of radiation is absorbed by the luminescent material 7, whereby radiation received at the output of the luminescent material 7 gives white light with the color rendering index greater than 80. This is achieved in that the luminescent composite material 7 uses an inorganic phosphor simultaneously with semiconductor nanocrystals that emit fluorescence signal with fluorescence peak maxima in the wavelength range of 580-650 nm.

**Fig. 9** shows another embodiment of the light emitting device for white light with multiple light sources 5, heat sink material 6, and luminescent composite material 7 located remotely from the light sources 5. The surface of the luminescent composite material may be of flat, convex or concave shape. The device further comprises a reflector 8 necessary to reduce losses due to a part of emitted light returned to the unit by reflection and re-emission. The reflection index of the reflector must be not less than 99%.

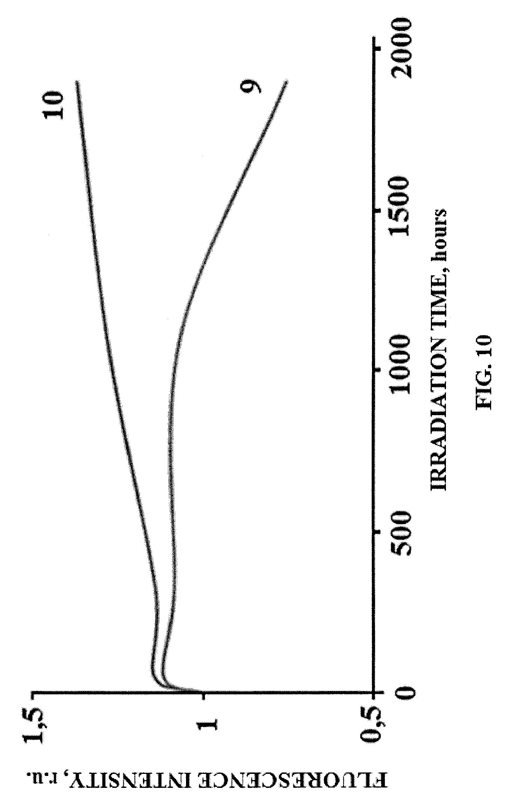

**Fig. 10** shows a graph of emission intensity (signal detection at 620 nm) of the light-emitting device based on the LED chip (450 nm, 12 W) and luminescent composite materials, the known and proposed ones. Number 9 designates the graph of the emission intensity change of the luminescent material based on semiconductor nanocrystals having CdSe/ZnS structure; number 10 designates a graph of emission intensity change for the proposed luminescent composite material containing yellow phosphor (yttrium-aluminum garnet doped with cerium) and semiconductor nanocrystals having CdSe/CdS/ZnS structure.

It is clear from these graphs that unlike the conventional fluorescent material, the fluorescence intensity of proposed luminescent composite material is maintained for a long time.

### INDUSTRIAL APPLICABILITY

Thus, the luminescent composite material obtained as described above allows manufacturing light emitting devices with the following characteristics:
- long life due to the new type of red phosphor - semiconductor nanocrystals and location of the luminescent composite material remote from the source of blue light;
- high color rendering index due to simultaneous use of inorganic phosphors fluorescing in the yellow-green spectrum region and semiconductor nanocrystals fluorescing in the orange-red spectrum region;
- high luminous efficiency due to luminescent composite material location away from blue light source and lamination of phosphor and inorganic semiconductor nanocrystals.

## Claims

1. Fluorescent composite material comprising a polymeric matrix (1) formed from an optically transparent polymeric material and a polymeric multilayer film containing phosphors, **characterized in that** the multilayer polymeric film comprises at least three layers, one of which represents an optically transparent polymer film (2), the other one is a polymeric composition (4) with dispersed semiconductor nanocrystals, and the third layer is a polymer composition (3) comprising inorganic phosphors, wherein the semiconductor nanocrystals are made of a semiconductor core, a first semiconductor layer and a second semiconductor layer, and they emit a fluorescent signal with fluorescence peak maxima in the wavelength range of 580-650 nm.

2. The material according **to claim 1, characterized in that** the semiconductor core consists of a semiconductor material selected from the group of: CdS, CdSe, CdTe, InP, InAs, CuInS₂, CuInSe₂.

3. The material according **to claim 1, characterized in that** the first semiconductor layer consists of a semiconductor material selected from the group of: ZnS, ZnSe, ZnTe, CdS, CdSe, CdTe, InP, InAs.

4. The material according **to claim 1, characterized in that** the second semiconductor layer consists of a semiconductor material selected from the group of: ZnS, ZnSe, ZnTe, CdS, CdSe, CdTe, InP, InAs.

5. The material according **to claim 1, characterized in that** inorganic phosphors are selected from the group consisting of: yttrium-aluminum garnets doped with cerium or gallium-gadolinium garnets doped with cerium.

6. The material according **to claim 1, characterized in that** optically transparent polymeric material or the material of the polymer film is selected from the group of:
polycarbonate, polymethylmethacrylate, polyvinylchloride or polystyrene.

7. The material according **to claim 6, characterized in that** the optically transparent polymer material or the material of the polymer film may further include a light-scattering additive, based on TiO₂, SiO₂, ZnO.

8. The material according **to claim 1, characterized in that** the polymer matrix is from 0.5 to 3 mm thick.

9. The material according **to claim 1, characterized in that** the polymer composition is made of polymethylmethacrylate, polyisocyanate or mixtures thereof.

10. The material according **to claim9, characterized in that** the polymer composition may further include a light-scattering additive based on TiO₂, SiO₂, ZnO.

11. The material according **to claim 1, characterized in that** the multilayered polymer film consists of layers arranged with respect to the polymer matrix as follows: an optically transparent polymer material, a polymer composition comprising inorganic phosphors, a polymer composition with dispersed semiconducting nanocrystals.

12. A light emitting device for generating white light, comprising a light source (5) and a luminescent composite material (7) located remote from the light source (5), **characterized in that** the light source (5) is made of an LED with the wavelength range of 430-470 nm, a part of radiation from which passes through the luminescent composite material (7) unchanged, while the other part of radiation is absorbed by the luminescent composite material (7), which is a polymeric matrix (1) made of an optically transparent polymer material with a multilayer polymeric film consisting of at least three layers, one of which is a polymer composition (3) comprising inorganic phosphors, the other one is optically transparent polymer material (2), and the third one is a polymeric composition (4) with dispersed semiconductor nanocrystals, wherein the nanocrystals are formed by a semiconductor core, a first semiconductor layer and a second semiconductor layer and emit a fluorescent signal with fluorescence peak maxima in the wavelength range of 580-650 nm, whereby radiation received at the output of the luminescent composite material (7) gives white light with a color rendering index greater than 80.

13. The device according **to claim12,** wherein is used the fluorescent composite material of one of the claims 1 to 11.

14. The device according **to claim 12, characterized in that** it further comprises a reflector (8).

15. The device according **to claim 12, characterized in that** the surface of the luminescent composite material (7) may have either flat, convex or concave shape.

## Patentansprüche

1. Fluoreszierendes Verbundmaterial, umfassend eine Polymermatrix (1), die aus einem optisch transparenten Polymermaterial hergestellt ist, und eine mehrschichtige Polymerfolie, die Phosphore enthält, **dadurch gekennzeichnet, dass** die mehrschichtige Polymerfolie wenigstens drei Schichten umfasst, von denen eine eine optisch transparente Polymerfolie (2) darstellt, die andere eine Polymerzusammensetzung (4) mit dispergierten Halbleiter-Nanokristallen ist und die dritte Schicht eine Polymerzusammensetzung (3) ist, die anorganische Phosphore umfasst, wobei die Halbleiter-Nanokristalle aus einem Halbleiterkern, einer ersten Halbleiterschicht und einer zweiten Halbleiterschicht hergestellt sind und ein fluoreszierendes Signal mit maximalen Fluoreszenz-Peaks im Wellenlängenbereich von 580-650 nm emittieren.

2. Material nach Anspruch 1, **dadurch gekennzeichnet, dass** der Halbleiterkern aus einem Halbleitermaterial besteht, das aus der der Gruppe von CdS, CdSe, CdTe, InP, InAs, CuInS₂, CuInSe₂ ausgewählt wird.

3. Material nach Anspruch 1, **dadurch gekennzeichnet, dass** die erste Halbleiterschicht aus einem Halbleitermaterial besteht, das aus der Gruppe von ZnS, ZnSe, ZnTe, CdS, CdSe, CdTe, InP, InAs ausgewählt wird.

4. Material nach Anspruch 1, **dadurch gekennzeichnet, dass** die zweite Halbleiterschicht aus einem Halbleitermaterial besteht, das aus der Gruppe von ZnS, ZnSe, ZnTe, CdS, CdSe, CdTe, InP, InAs ausgewählt wird.

5. Material nach Anspruch 1, **dadurch gekennzeichnet, dass** anorganische Phosphore aus der Gruppe ausgewählt werden, die aus mit Cerium dotiertem Yttrium-Aluminium-Granat oder mit Cerium dotiertem Gallium-Gadolinium-Granat besteht.

6. Material nach Anspruch 1, **dadurch gekennzeichnet, dass** das optisch transparente Polymermaterial oder das Material der Polymerfolie aus der Gruppe von Polycarbonat, Polymethylmethacrylat, Polyvinylchlorid oder Polystyrol ausgewählt wird.

7. Material nach Anspruch 6, **dadurch gekennzeichnet, dass** das optisch transparente Polymermaterial oder das Material der Polymerfolie weiterhin ein lichtstreuendes Additiv auf der Grundlage von TiO₂, SiO₂, ZnO aufweisen kann.

8. Material nach Anspruch 1, **dadurch gekennzeichnet, dass** die Polymermatrix 0,5 bis 3 mm dick ist.

9. Material nach Anspruch 1, **dadurch gekennzeichnet, dass** die Polymerzusammensetzung aus Polymethylmethacrylat, Polyisocyanat oder Mischungen daraus hergestellt ist.

10. Material nach Anspruch 9, **dadurch gekennzeichnet, dass** die Polymerzusammensetzung weiterhin ein lichtstreuendes Additiv auf der Grundlage von TiO₂, SiO₂, ZnO aufweisen kann.

11. Material nach Anspruch 1, **dadurch gekennzeichnet, dass** die mehrschichtige Polymerfolie aus Schichten besteht, die bezüglich der Polymermatrix wie folgt angeordnet sind: ein optisch transparentes Polymermaterial, eine Polymerzusammensetzung, die anorganische Phosphore umfasst, eine Polymerzusammensetzung mit dispergierten Halbleiter-Nanokristallen.

12. Lichtemittierende Vorrichtung zur Erzeugung von weißem Licht, umfassend eine Lichtquelle (5) und ein lumineszierendes Verbundmaterial (7), das von der Lichtquelle (5) entfernt angeordnet ist, **dadurch gekennzeichnet, dass** die Lichtquelle (5) aus einer LED mit einem Wellenlängenbereich von 430-470 nm hergestellt ist, wobei ein Teil von deren Strahlung unverändert durch das lumineszierende Verbundmaterial (7) hindurchgeht, während der andere Teil der Strahlung von dem lumineszierenden Verbundmaterial (7) absorbiert wird, das eine Polymermatrix (1) ist, die aus einem optisch transparenten Polymermaterial mit einer mehrschichtigen Polymerfolie hergestellt ist, die aus wenigstens drei Schichten besteht, von denen eine eine Polymerzusammensetzung (3) ist, die anorganische Phosphore umfasst, die andere ein optisch transparentes Polymermaterial (2) ist und die dritte eine Polymerzusammensetzung (4) mit dispergierten Halbleiter-Nanokristallen ist, wobei die Nanokristalle von einem Halbleiterkern, einer ersten Halbleiterschicht und einer zweiten Halbleiterschicht gebildet werden und ein fluoreszierendes Signal emittieren, dessen maximale Fluoreszenz-Peaks in dem Wellenlängenbereich von 580-650 nm liegen, wodurch Strahlung, die am Ausgang des lumineszierenden Verbundmaterials (7) empfangen wird, weißes Licht mit einem Farbwiedergabeindex von mehr als 80 erzeugt.

13. Vorrichtung nach Anspruch 12, bei der das fluoreszierende Verbundmaterial nach einem der Ansprüche 1 bis 11 verwendet wird.

14. Vorrichtung nach Anspruch 12, **dadurch gekennzeichnet, dass** sie weiterhin einen Reflektor (8) umfasst.

15. Vorrichtung nach Anspruch 12, **dadurch gekennzeichnet, dass** die Oberfläche des lumineszierenden Verbundmaterials (7) eine entweder flache, konvexe oder konkave Form haben kann.

## Revendications

1. Matériau composite fluorescent comprenant une matrice polymère (1) formée à partir d'un matériau polymère optiquement transparent et d'un film multicouche polymère contenant des phosphores, **caractérisé en ce que** le film polymère multicouche comprend au moins trois couches, dont une représente un film polymère optiquement transparent (2), l'autre est une composition polymère (4) avec des nanocristaux semi-conducteurs dispersés, et la troisième couche est une composition polymère (3) comprenant des phosphores inorganiques, les nanocristaux semi-conducteurs étant constitués par un coeur semi-conducteur, une première couche semi-conductrice et une deuxième couche semi-conductrice et ils émettent un signal fluorescent avec des maximums de pics de fluorescence dans la plage de longueurs d'onde de 580-650 nm.

2. Matériau selon **la revendication 1, caractérisé en ce que le** coeur semi-conducteur est constitué par un matériau semi-conducteur sélectionné dans le groupe constitué par : CdS, CdSe, CdTe, InP, InAs, CuInS₂, CuInSe₂.

3. Matériau selon **la revendication 1, caractérisé en ce que** la première couche semi-conductrice est constituée par un matériau sélectionné dans le groupe constitué par : ZnS, ZnSe, ZnTe, CdS, CdSe, CdTe, InP, InAs.

4. Matériau selon **la revendication 1, caractérisé en ce que** la deuxième couche semi-conductrice est constituée par un matériau sélectionné dans le groupe constitué par : ZnS, ZnSe, ZnTe, CdS, CdSe, CdTe, InP, InAs.

5. Matériau selon **la revendication 1, caractérisé en ce que** les phosphores inorganiques sont sélectionnés dans le groupe constitué par : les grenats d'yttrium-aluminium dopés au cérium ou les grenats de gallium-gadolinium dopés au cérium.

6. Matériau selon **la revendication 1, caractérisé en ce que** le matériau optiquement transparent ou le matériau du film polymère est sélectionné dans le groupe constitué par : le polycarbonate, le polyméthacrylate de méthyle, le polychlorure de vinyle ou le polystyrène.

7. Matériau selon **la revendication 6, caractérisé en ce que** le matériau polymère optiquement transparent ou le matériau du film polymère peut comprendre en outre un additif de diffusion de la lumière, à base de TiO₂, SiO₂, ZnO.

8. Matériau selon **la revendication 1, caractérisé en ce que** la matrice polymère a une épaisseur de 0,5 à 3 mm.

9. Matériau selon **la revendication 1, caractérisé en ce que** la composition polymère est constituée de polyméthacrylate de méthyle, de polyisocyanate ou de mélange de ceux-ci.

10. Matériau selon **la revendication 9, caractérisé en ce que** la composition polymère peut comprendre en outre un additif de diffusion de la lumière à base de TiO₂, SiO₂, ZnO.

11. Matériau selon **la revendication 1, caractérisé en ce que** le film polymère multicouche est constitué par des couches agencées par rapport à la matrice polymère de la manière suivante : un matériau polymère optiquement transparent, une composition polymère comprenant des phosphores inorganiques, une composition polymère avec des nanocristaux semi-conducteurs dispersés.

12. Dispositif d'émission de lumière destiné à générer une lumière blanche, comprenant une source de lumière (5) et un matériau composite luminescent (7) situé à distance de la source de lumière (5), **caractérisé en ce que** la source de lumière (5) est constituée par une LED avec la plage de longueurs d'onde de 430-470 nm, dont une partie du rayonnement passe à travers le matériau composite luminescent (7) inchangée, tandis que l'autre partie du rayonnement est absorbée par le matériau composite luminescent (7), qui est une matrice polymère (1) constituée par un matériau polymère transparent avec un film polymère multicouche constitué par au moins trois couches, dont une est une composition polymère (3) comprenant des phosphores inorganiques, l'autre est un matériau polymère optiquement transparent (2) et la troisième est une composition polymère (4) avec des nanocristaux semi-conducteurs dispersés, les nanocristaux étant formés par un coeur semi-conducteur, une première couche semi-conductrice et une deuxième couche semi-conductrice et émettant un signal fluorescent avec des maximums de pics de fluorescence dans la plage de longueurs d'onde de 580-650 nm, moyennant quoi le rayonnement reçu à la sortie du matériau composite luminescent (7) génère une lumière blanche avec un indice de rendu des couleurs supérieur à 80.

13. Dispositif selon **la revendication 12,** le matériau composite fluorescent de l'une des revendications 1 à 11 étant utilisé.

14. Dispositif **selon la revendication 12, caractérisé en ce qu'il** comprend en outre un réflecteur (8).

15. Dispositif **selon la revendication 12, caractérisé en ce que** la surface du matériau composite luminescent (7) peut avoir une forme soit plate, soit convexe, soit concave.
